Europäisches Patentamt

European Patent Office

Office européen des brevets

(19)

(11) Veröffentlichungsnummer: **0 268 109 B1**

(12) **EUROPÄISCHE PATENTSCHRIFT**

(45) Veröffentlichungstag der Patentschrift: **03.07.91**

(51) Int. Cl.5: **B23H 1/02**

(21) Anmeldenummer: **87115674.1**

(22) Anmeldetag: **26.10.87**

(54) **Impulsgenerator zur funkenerosiven Metallbearbeitung.**

(30) Priorität: **17.11.86 DE 3639256**

(43) Veröffentlichungstag der Anmeldung:
**25.05.88 Patentblatt 88/21**

(45) Bekanntmachung des Hinweises auf die
Patenterteilung:
**03.07.91 Patentblatt 91/27**

(84) Benannte Vertragsstaaten:
**CH DE FR GB IT LI LU SE**

(56) Entgegenhaltungen:

**PATENT ABSTRACTS OF JAPAN, Band 4, Nr. 37 (M-4)[519], 27. März 1980; & JP-A-55 11 730 (MITSUBISHI DENKI K.K.), 26-01-1980**

(73) Patentinhaber: **AG für industrielle Elektronik AGIE Losone bei Locarno**

**CH-6616 Losone/Locarno(CH)**

(72) Erfinder: **Bühler, Ernst
Salita degli Orti
CH-6616 Losone(CH)**

(74) Vertreter: **EGLI-EUROPEAN PATENT ATTORNEYS
Widenmayerstrasse 5
W-8000 München 22(DE)**

## Beschreibung

Die Erfindung bezieht sich auf einen Impulsgenerator zur funkenerosiven Metallbearbeitung gemäß dem Oberbegriff des Patentanspruches 1 (vgl. DE-PS 24 41 734).

Die Tendenz in der Funkenerosionstechnik geht zu immer höheren Bearbeitungsgeschwindigkeiten. Entsprechend benötigt man Impulsgeneratoren, die hohe Energien mit hoher Wiederholfrequenz zur Funkenstrecke liefern können. Besonders auf dem Gebiet des funkenerosiven Drahtschneidens und Bohrens benötigt man Hochenergieimpulse mit definierter, sehr kurzer Impulszeit.

Aus der DE-PS 27 35 403 (= US-PS 4,163,887) ist bereits ein Impulsgenerator bekannt, der einen Impulsstrom bis 500 A im $1\mu s$-Bereich liefert. Heutige Forderungen liegen bei Impulsströmen bis 1000 Å bei etwa $2\mu s$. Bei solch extremen Werten wird der genannte Generatortyp zu groß und ist auch aus Gründen seines schlechten Wirkungsgrades von typisch 10% zu unwirtschaftlich.

Aus der DE-PS 34 19 945 ist ein Generator mit einem Wirkungsgrad von besser als 60% bekannt. Da dieser Generator für alle funkenerosiven Bearbeitungsarten ausgelegt ist, wird er für die oben genannten Anwendungen technisch zu aufwendig. Auch müssen die dort verwendeten Schaltelemente den vollen Spitzenstrom ausschalten, was sich in unnötigen Schaltverlusten niederschlägt.

Die DE-PS 24 41 734 zeigt einen Impulsgenerator, bei dem mittels eines elektronisch gesteuerten Ladereglers ein Speicherkondensator linear aufgeladen wird und bei Erreichen der Ladespannung über ein Schaltelement und einen Trenntransformator in die Funkenstrecke entladen wird. Generatoren dieser Art sind technisch aufwendig und in der Steuerbarkeit begrenzt, da die Entladung dann ausgelöst werden muß, wenn der Speicherkondensator fertig geladen ist, was unter Umständen mit ungünstigen Verhältnissen in der Funkenstrecke zusammenfällt.

Ein weiterer Generator ist in der US-PS 3,485,987 beschrieben. Dort wird der Ladestrom für einen Speicherkondensator über einen Trenntransformator in den Erosionskreis eingekoppelt. Der Speicherkondensator wird dabei abwechselnd über ein erstes Schaltelement aufgeladen und über ein zweites Schaltelement entladen.

Allerdings hat diese Anordnung den großen Nachteil, daß bei einem "Leerlaufimpuls", bei dem also die Funkenstrecke nicht zündet, der Speicherkondensator nicht umgeladen wird, so daß die Schaltung dann erst für den übernächsten Impuls wieder funktionsfähig ist. Zudem ergeben sich über den Trenntransformator Rückwirkungen zwischen den beiden Schaltelementen, die nur durch großen Aufwand an Schutzbeschaltung zu beherrschen sind.

Es sind auch verschiedene andere Schwingkreis-Generatorschaltungen bekannt, die den Vorteil haben, daß die Schaltelemente stromlos oder nur bei geringem Strom kommutieren.

Ein wesentlicher Nachteil von Generatoren mit elektronisch gesteuerten Ladereglern liegt darin, daß sie hohen technischen Aufwand benötigen und teilweise sogar eine Verschlechterung des Gesamtwirkungsgrades mit sich bringen. Schwingkreisgeneratoren ohne gesteuerte Laderegler haben den Nachteil schlecht kontrollierbarer Stromimpulse (über die Funkenstrecke), da der Ladezustand des Speicherkondensators stark vom vorhergehenden Impuls beeinflußt wird.

Aufgabe der vorliegenden Erfindung ist es, den gattungsgemäßen Impulsgenerator dahingehend zu verbessern, daß Hochenergieimpulse bei gutem Wirkungsgrad erzeugt werden können. Hierzu soll der Ladezustand der Speicherkondensatoren unabhängig von vorhergehenden Entladungen sein, wobei die Schaltung einfach aufgebaut, räumlich klein und betriebsicher sein soll.

Bei dem gattungsgemäßen Impulsgenerator wird diese Aufgabe durch die im kennzeichnenden Teil des Patentanspruches 1 angegebenen Merkmale gelöst. Vorteilhafte Ausgestaltungen und Weiterbildungen der Erfindung sind den Unteransprüchen zu entnehmen.

Mit der Erfindung erreicht man die Vorteile, daß die Schaltelemente optimal ausgenutzt werden, da nur im stromlosen Zustand kommutiert wird. Da im Lade- und Entladekreis im wesentlichen nur sinusförmige Impulse fließen, erhält man bei gleichem Spitzenwert des Stromes einen um mehr als 27% höheren Energieinhalt als bei den sonst üblichen dreieckförmigen Impulsen. Zudem werden die Nachteile der bekannten Schaltungen vermieden. Insbesondere betrifft dies den Wirkungsgrad, die Definition des Ladezustandes des Speicherkondensators und die Komplexität und damit die Zuverlässigkeit und Baugröße der Schaltung.

Durch die Anwendung von Hochenergieimpulsen wird der Erosionsprozeß beim Drahtschneiden und beim funkenerosiven Bohren erheblich verbessert, da selbst metallische Kurzschlüsse zwischen Werkstück und Elektrode durch ohmsche Aufheizung aufgeschmolzen (bis zur Verdampfung von Teilen des Werkstücks und/ oder der Elektrode) und in eine abtragswirksame Plasmaentladung überführt werden können. Dies ist aber aus Gründen des geringen spezifischen Widerstandes der Metalle erst ab Impulsströmen über etwa 500 A wirkungsvoll möglich.

Impulsgeneratoren nach der Erfindung sind besonders klein und leicht. Auf einer Doppeleuropa-Steckkarte läßt sich z.B. eine Schaltung mit einem Spitzenstrom von 150A bequem unterbringen, wobei in einem 19-Zoll-Rack ein 900A-Generator realisiert werden kann. Dies ist im Vergleich zu den heutigen Generatoren eine Volumenverkleinerung um mindestens den Faktor 10.

Im folgenden werden Ausführungsbeispiele der Erfindung im Zusammenhang mit der Zeichnung ausführlicher erläutert. Es zeigt:

Fig. 1     ein erstes Ausführungsbeispiel der Erfindung mit einem Sperrwandlertransformator in der Ladereglerschaltung,

Fig. 2     ein zweites Ausführungsbeispiel der Erfindung mit zwei Speicherkondensatoren und einer Induktivität in der Ladereglerschaltung.

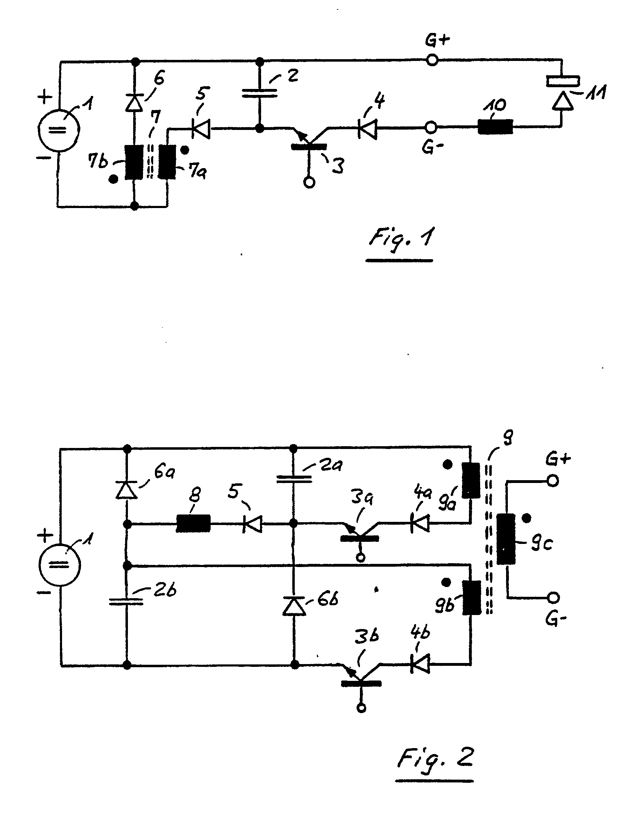

In Fig. 1 erkennt man sofort den einfachen Aufbau der Schaltung. Eine Gleichspannungsquelle 1 ist mit ihrem einen Pol (+) mit einem Speicherkondensator 2 verbunden. Parallel zu dem Speicherkondensator liegt ein Entladekreis bestehend aus einer Reihenschaltung aus einem Schaltelement 3, einer Rückschwingsperrdiode 4, einer Zuleitungsinduktivität 10 und einer Funkenstrecke 11. Mit G+ und G- sind die Ausgangsanschlüsse des Generators gekennzeichnet.

Der Ladekreis zur Aufladung des Speicherkondensators 2 enthält eine an den anderen Pol des Speicherkondensators 2 angeschlossene Umladediode 5 und eine dazu in Reihe geschaltete Primärwicklung 7a eines Sperrwandlertransformators 7, wobei der andere Anschluß der Primärwicklung 7a mit dem Minuspol der Gleichspannungsquelle 1 verbunden ist. Parallel zu der Gleichspannungsquelle 1 liegt eine Reihenschaltung aus einer Sekundärwicklung 7b des Sperrwandlertransformators 7 und einer Rekuperationsdiode 6. Die beiden Wicklungen 7a und 7b des Sperrwandlertransformators 7 sind entsprechend den in Fig. 1 dargestellten Punkten gepolt.

Die Schaltung der Fig. 1 arbeitet wie folgt: Beim Einschalten der Gleichspannungsquelle 1 wird der Speicherkondensator 2 über die Umladediode 5 und die Induktivität der Primärwicklung 7a auf ungefähr die doppelte Spannung der Gleichspannungsquelle aufgeladen. Die Rekuperationsdiode 6 wird bei diesem Vorgang nur leitend, wenn das Übersetzungsverhältnis (7a : 7b) des Sperrwandlertransformators 7 kleiner als 1 ist. Wird nun das Schaltelement 3 leitend geschaltet, so wird der Speicherkondensator über die Funkenstrecke 11, die Zuleitungsinduktivität 10, die Rückschwingsperrdiode 4 und das Schaltelement 3 entladen, wobei ein Teil der gespeicherten Energie in Funkenergie umgesetzt wird. Der größere Teil der gespeicherten Energie fließt jedoch in den Speicherkondensator 2 zurück und lädt diesen wieder mit umgekehrter Polarität auf. Die Rückschwingsperrdiode 4 verhindert dabei eine erneute Entladung, die einen unerwünschten, negativen Stromimpuls, der einen erheblichen Verschleiß der Elektrode bewirkt, verursachen würde. Sobald während der Entladung die Spannung des Speicherkondensators 2 kleiner wird als die der Gleichspannungsquelle 1 beginnt ein sinusförmiger Ladestrom über die Umladediode 5, die Induktivität der Primärwicklung 7a und die Gleichspannungsquelle 1 zu fließen. Der Sperrwandlertransformator 7 ist dabei so gepolt, daß in dieser Phase die Rekuperationsdiode 6 in Sperrichtung beansprucht wird. Die Gleichspannungsquelle 1 erzeugt bei diesem Umladevorgang einen Energieüberschuß, der gleich dem Strom-Zeitintegral des Ladestromes mal der Spannung der Gleichspannungsquelle 1 ist. Die Schaltung ist dabei so zu dimensionieren, daß dieser Energieüberschuß gerade so groß ist, daß er die Funkenenergie und die Verluste in der Schaltung selber deckt. Ist nun bei einer Entladung die verbrauchte Energie kleiner als der vorgesehene Energieüberschuß, so wird der Speicherkondensator 2 nur soweit aufgeladen, bis die in der Sekundärwicklung 7b selbstinduzierte Spannung größer wird als die der Gleichspannungsquelle 1. Ab diesem Moment beginnt nämlich die Rekuperationsdiode 6 zu leiten, womit die überschüssige, in der Induktivität des Sperrwandlertransformators 7 gespeicherte Energie in die Gleichspannungsquelle 1 zurückgeführt wird. Der Sperrwandlertransformator 7 wird vorzugsweise mit Ferritkernen und Luftspalt aufgebaut, wobei die bekannte bifilare Wickeltechnik angewendet werden sollte, um trotz Luftspalt eine gute magnetische Kopplung zu erreichen. Nimmt man an, die Spannung der Gleichspannungsquelle 1 sei E und das Übersetzungsverhältnis der Primärwicklung 7a zur Sekundärwicklung 7b sei n, so wird die Ladespannung des Speicherkondensators $2 = E \cdot (1+n)$. Die Umladediode 5 muß für eine Spannung von mindestens $E \cdot 2n$ dimensioniert werden und die Rekuperationsdiode 6 für eine solche von $E \cdot (2+2/n)$. Für einen kleinen Generator sind typische Werte für E = 100V und für N = 2, was eine Ladespannung von 300V ergibt und die Verwendung von effizienten 400V-Dioden ermöglicht. Für höhere Entladeströme und bei höheren Werten der Zuleitungsinduktivität 10 kann man gezwungen sein, mit Ladespannungen von 500V bis über 1000V zu arbeiten.

Generell erkennt man aus Fig. 1, daß für die Laderegelung des Kondensators keine gesteuerten Bauelemente benötigt werden. Vielmehr sind rein passive Bauelemente wie Dioden und Induktivitäten eines Sperrwandlers ausreichend. Damit der Energieüberschuß des Speicherkondensators nach der Funkenentladung zur Gleichspannungsquelle 1 zurückgeleitet werden kann, darf das Schaltelement 3 dann erst erneut leitend geschaltet werden, wenn der Umladestrom durch die Umladediode 5 im wesentlichen abgeklungen ist. Das Schaltelement 3 wird durch einen (nicht dargestellten) Impulsgenerator angesteuert, dessen maximale Schaltfrequenz so limitiert ist, daß sichergestellt ist, daß eine neue Entladung erst dann ausgelöst werden kann (leitend werden des Schaltelementes 3), wenn die Rekuperation abgeschlossen ist. Die Impulsdauer dieser Ansteuerimpulse für das Schaltelement 3 ist dabei so lang gewählt, daß das Schaltelement 3 erst dann sperrt, wenn der Entladestrom sicher abgeklungen ist.

In Fig. 2 ist ein zweites Ausführungsbeispiel der Erfindung dargestellt. Das Wirkungsprinzip ist dem der Fig. 1 sehr ähnlich. Im Unterschied zur Schaltung der Fig. 1 sind zwei Speicherkondensatoren 2a und 2b und zwei Entladekreise 3a, 4a, 9a; 3b, 4b, 9b vorgesehen. Im einzelnen ist diese Schaltung wie folgt aufgebaut. Parallel zur Gleichspannungsquelle 1 liegt eine Reihenschaltung aus einem ersten Speicherkondensator 2a und einer in Sperrichtung geschalteten Rekuperationsdiode 6b. Ebenso liegt parallel zur Gleichspannungsquelle 1 eine weitere Reihenschaltung aus einer Rekuperationsdiode 6a und einem zweiten Speicherkondensator 2b (der Buchstabe a bezeichnet wirkungsmäßig einen Kreis, während der Buchstabe b wirkungsmäßig den zweiten Kreis bezeichnet). Die beiden gemeinsamen Verbindungspunkte zwischen dem Speicherkondensator 2a und der Rekuperationsdiode 6b einerseits und dem Speicherkondensator 2b und der Rekuperationsdiode 6a andererseits sind durch eine Reihenschaltung aus der Umladediode 5 und einer Induktivität 8 miteinander verbunden.

Parallel zum ersten Speicherkondensator 2a liegt eine Reihenschaltung bestehend aus einer Primärwicklung 9a eines Trenntransformators 9, einer Rückschwingsperrdiode 4a und eines Schaltelementes 3a. In entsprechender Weise liegt parallel zum zweiten Speicherkondensator 2b eine Reihenschaltung aus einer weiteren Primärwicklung 9b des Trenntransformators 9, einer Rückschwingsperrdiode 4b und einem Schaltelement 3b. Eine Sekundärwicklung 9c des Trenntransformators ist mit den beiden Primärwicklungen 9a und 9b magnetisch gekoppelt. Die beiden Anschlüsse der Sekundärwicklung 9c stellen die Generatoranschlüsse G+ und G- dar, an die dann die Funkenstrecke 11 (mit ihrer Zuleitungsinduktivität 10) gemäß Fig. 1 anzuschließen ist.

Die Arbeitsweise dieser Schaltung ist wie folgt: Die Ladereglerschaltung mit den Bauelementen 5 bis 8 arbeitet hier mit einem festen Energieüberschuß, der sich pro Speicherkondensator 2a, 2b aus der halben Spannung der Gleichspannungsquelle 1 mal dem Ladestromzeitintegral ergibt.

Beim Einschalten der Gleichspannungsquelle 1 werden beide Speicherkondensatoren 2a und 2b über die Umladediode 5 und die Induktivität 8 auf ungefähr die Spannung der Gleichspannungsquelle 1 aufgeladen. Der Entladevorgang funktioniert im wesentlichen gleich wie bei der ersten Schaltung mit dem Unterschied, daß die zwei Schaltelemente 3a und 3b synchron und gleichzeitig durchgeschaltet werden und damit die Entladung der ihnen zugeordneten Speicherkondensatoren 2a bzw. 2b auslösen, wobei dann die zwei Impulsströme dieser Kondensatoren über die zwei Primärwicklungen 9a und 9b auf den Generatorausgang ausgekoppelt werden. Dies hat den Vorteil, daß die Gleichspannungsquelle 1 nicht galvanisch vom Netz getrennt werden muß. Auch kann man die Spannung am Generatorausgang (G+, G-) mit dem Übersetzungsverhältnis des Trenntransformators anpassen. Der nachfolgende Ladevorgang der Speicherkondensatoren 2a, 2b geschieht wieder über die Umladediode 5 und die Induktivität 8, solange, bis die Speicherkondensatoren 2a und 2b auf die Spannung der Gleichspannungsquelle 1 aufgeladen sind. Sodann werden die Rekuperationsdioden 6a und 6b leitend und der in der Induktivität 8 verbliebene Energieüberschuß wird in die Gleichspannungsquelle 1 rekuperiert. Die Umladezeit kann über die Größe der Induktivität 8 gewählt werden. Diese Umladezeit wird einerseits möglichst kurz gewählt (z.B. 5 bis 10 μs), um hohe Impulsfrequenzen zu ermöglichen, andererseits wird aber bei zu kurzer Umladezeit der Ladestrom unnötig hoch und die Zeit zu kurz, um die Schaltelemente 3a und 3b in den nichtleitenden Zustand zu bringen. Dasselbe gilt übrigens analog für die Schaltung nach Fig. 1.

Als Schaltelemente 3, 3a und 3b eignen sich für beide Schaltungen der heute verfügbaren, schnellen elektronischen Schalter vom Bipolartransistor über MOSFET, GTO, SCR bis in Extremfällen zum Wasserstoffthyratron. Rückwärtssperrende Schalter, wie z.B. Thyristoren, können dabei auch die Funktion der Rückschwingsperrdioden 4, 4a, 4b übernehmen, was zu einer weiteren Vereinfachung der Schaltungen beiträgt.

Auch bei der Schaltung der Fig. 2 ergibt sich im übrigen die Wicklungspolarität der Wicklungen 9a, 9b und 9c aus den abgebildeten Punkten.

**Ansprüche**

1. Impulsgenerator zur funkenerosiven Metallbearbeitung mit
   - einer Gleichspannungsquelle (1),
   - mindestens einer Ladereglerschaltung (5-8), die die Aufladung mindestens eines Speicherkondensators (2, 2a, 2b) steuert und mit mindestens einem Schaltelement (3, 3a, 3b), das den mindestens einen Speicherkondensator mit einer Funkenstrecke (11) verbindet, wobei im Stromkreis zwischen dem Speicherkondensator und der Funkenstrecke eine Rückschwingsperrdiode (4, 4a, 4b) vorgesehen ist,

dadurch **gekennzeichnet,**

daß die Ladereglerschaltung nur ungesteuerte Bauelemente (5-8) enthält und so dimensioniert ist, daß der Speicherkondensator (2, 2a, 2b) mit Energieüberschuß aufgeladen wird,

daß der nach der Umladung des Speicherkondensators (2, 2a, 2b) über die eine Umladediode (5) noch vorhandene Energieüberschuß über mindestens eine Rekuperationsdiode (6, 6a, 6b) in die Gleichspannungsquelle zurückgeleitet wird und

daß das Schaltelement (3, 3a, 3b) erst nach Abklingen des Entladestromes nichtleitend geschaltet wird.

2. Impulsgenerator nach Anspruch 1, dadurch gekennzeichnet, daß der Speicherkondensator (2) einerseits an einem Pol (+) der Gleichspannungsquelle (1) angeschlossen ist und andererseits über eine Umladediode (5) und eine Primärwicklung (7a) eines Sperrwandlertransformators (7) am anderen Pol (-) der Gleichspannungsquelle (1) angeschlossen ist und daß die Sekundärwicklung (7b) des Sperrwandlertransformators (7) über die Rekuperationsdiode (6) so an die Gleichspannungsquelle (1) angeschlossen ist, daß die Rekuperationsdiode (6) leitend wird, wenn die selbstinduzierte Spannung in der Sekundärwicklung (7b) die Spannung der Gleichspannungsquelle (1) übersteigt, wobei die Ladespannung des Speicherkondensators (2) durch die Gleichspannungsquelle (1) und das Übersetzungsverhältnis des Sperrwandlertransformators (7) festgelegt ist.

3. Impulsgenerator nach Anspruch 1, dadurch gekennzeichnet, daß ein erster Speicherkondensator (2b) einerseits an einem ersten Pol (-) der Gleichspannungsquelle (1) und andererseits über eine erste Rekuperationsdiode (6a) an den zweiten Pol (+) der Gleichspannungsquelle angeschlossen ist, daß ein zweiter Speicherkondensator (2a) einerseits an den zweiten Pol (+) der Gleichspannungsquelle und andererseits über eine zweite Rekuperationsdiode (6b) an den ersten Pol (-) der Gleichspannungsquelle angeschlossen ist, daß die Speicherkondensatoren (2a, 2b) synchron bzw. im Gleichtakt über je eine Primärwicklung (9a, 9b) eines Trenntransformators (9), je eine Rückschwingsperrdiode (4a, 4b) und je ein Schaltelement (3a, 3b) über die Funkenstrecke (11) entladen werden und daß die Speicherkondensatoren (2a, 2b) über eine Umladediode (5) und eine Induktivität (8), welche die den Speisungspolen abgewandten Seiten der Speicherkondensatoren (2a, 2b) verbinden, wieder aufgeladen werden, bis die Rekuperationsdioden (6a, 6b) leitend werden, wobei die Ladespannung der Speicherkondensatoren (2a, 2b) durch die Spannungsquelle (1) bestimmt ist.

## Claims

1. A pulse generator for spark-erosion metalworking with
   - a direct current source (1),
   - at least one charge control circuit (5-8), which controls the charging of at least one storage capacitor (2, 2a, 2b), and with at least one switching element (3, 3a, 3b), which connects at least one storage capacitor to a spark gap (11), a reverse oscillation blocking diode (4, 4a, 4b) being provided in the circuit between the storage capacitor and the spark gap, characterised in that the charge control circuit contains only uncontrolled components (5-8) and is dimensioned in such a way that the storage capacitor (2, 2a, 2b) is charged with an energy surplus, in that the energy surplus which is still available via one recharging diode (5) after the recharging of the storage capacitor (2, 2a, 2b) is fed back to the direct current source via at least one recovery diode (6, 6a, 6b) and in that the switching element (3, 3a, 3b) is not switched so as to be non-conducting until after the decay of the discharge current.

2. A pulse generator according to claim 1, characterised in that the storage capacitor (2) is connected on the one hand to a pole (+) of the direct current source (1) and is connected on the other hand to the other pole (-) of the direct current source (1) via a recharging diode (5) and a primary winding (7a) of a blocking oscillator transformer (7), and in that the secondary winding (7b) of the blocking oscillator transformer (7) is connected to the direct current source (1) via the recovery diode (6) in such a way that the recovery diode (6) becomes conductive if the self-induced voltage in the secondary winding (7b) exceeds the voltage of the direct current source (1), the charging voltage of the storage capacitor (2) being determined by the direct current source (1) and the transformation ratio of the blocking oscillator transformer (7).

3. A pulse generator according to claim 1, characterised in that a first storage capacitor (2b) is connected on the one hand to a first pole (-) of the direct current source (1) and on the other hand to the second pole (+) of the direct current source via a first recovery diode (6a), in that a second storage capacitor (2a) is connected on the one hand to the second pole (+) of the direct current source and on the other hand to the first pole (-) of the direct current source via a second recovery diode (6b), in that the storage capacitors (2a, 2b) are discharged over the spark gap (11) in a synchronous manner or in common mode, each via a primary winding (9a, 9b) of an isolating transformer (9), a reverse oscillation blocking diode (4a, 4b) and a switching element (3a, 3b) and in that the storage capacitors (2a, 2b) are charged again via a recharging diode (5) and an inductor (8), which connect the sides of the storage capacitors (2a, 2b) facing away from the supply poles, until the recovery diodes (6a, 6b) become conductive, the charging voltage of the storage capacitors (2a, 2b) being determined by the voltage source (1).

**Revendications**

1. Générateur d'impulsions destiné à l'usinage des métaux par électro-érosion, comportant:
   - une source de tension continue (1),
   - au moins un commutateur de régulation de charge (5 à 8) qui commande la charge d'au moins un condensateur d'accumulation (2, 2a, 2b) et au moins un élément de commutation (3, 3a, 3b) qui connecte le condensateur d'accumulation, au nombre d'au moins un, à un éclateur à étincelles (11), une diode de blocage à rétro-oscillation (4, 4a, 4b) étant prévue dans le circuit de courant entre le condensateur d'accumulation et l'éclateur à étincelles,
   caractérisé en ce que:
   - le commutateur de régulation de charge ne contient que des modules non commandés (5 à 8) et est dimensionné de façon telle que le condensateur d'accumulation (2, 2a, 2b) soit chargé avec un excédent d'énergie;
   - l'excédent d'énergie qui existe encore après la décharge du condensateur d'accumulation (2, 2a, 2b) par l'intermédiaire d'une diode de décharge ou de transfert de charge (5) est ramené à la source de tension continue par l'intermédiaire d'au moins une diode de récupération ou de roue libre (6, 6a, 6b); et
   - l'élément de commutation (3, 3a, 3b) n'est sur la position non conductrice qu'après l'évanouissement du courant de décharge.

2. Générateur d'impulsions selon la revendication 1, caractérisé en ce que le condensateur d'accumulation (2) est connecté, d'une part, à un pôle (+) de la source de tension continue (1) et, d'autre part, par l'intermédiaire d'une diode de décharge ou de transfert de charge (5) et d'un enroulement primaire (7a) d'un transformateur de blocage, à l'autre pôle (-) de la source de tension continue (1) et en ce que l'enroulement secondaire (7b) du transformateur de blocage (7) est connecté à la source de tension continue (1) par l'intermédiaire de la diode de récupération (6), de telle façon que celle-ci devienne conductrice lorsque la tension auto-induite dans l'enroulement secondaire (7b) dépasse la tension de la source de tension continue (1), la tension de charge du condensateur d'accumulation (2) étant déterminée par la source de tension continue (1) et par le rapport de transformation du transformateur de blocage (7).

3. Générateur d'impulsions selon la revendication 1, caractérisé en ce qu'un premier condensateur d'accumulation (2b) est raccordé, d'une part à un premier pôle (-) de la source de tension continue et, d'autre part, via une première diode de récupération (6a) au deuxième pôle (+) de la source de tension continue, en ce qu'un deuxième condensateur d'accumulation (2a) est raccordé, d'une part, au deuxième pôle (+) de la source de tension continue et, d'autre part, via une deuxième diode de récupération (6b) au premier pôle (-) de la source de tension continue, en ce que les condensateurs d'accumulation (2a, 2b) sont déchargés en synchronisme ou en phase sur l'éclateur à étincelles (11), chacun via un bobinage primaire (9a, 9b) d'un transformateur de séparation (9), via une diode de blocage à rétro-oscillation (4a, 4b) et via un élément de commutation (3a, 3b) et en ce que les condensateurs d'accumulation (2a, 2b) sont rechargés via une diode de recharge (5) et une inductance (8) qui relie les plaques des condensateurs d'accumulation (2a, 2b) tournées vers les pôles d'alimentation, jusqu'à ce que les diodes de récupération (6a, 6b) deviennent conductrices, la tension de charge des condensateurs d'accumulation (2a, 2b) étant déterminée par la source de tension (1).

*Fig. 1*

*Fig. 2*